Europäisches Patentamt

European Patent Office

Office européen des brevets

(11) Publication number: **0 285 028**
**A2**

## EUROPEAN PATENT APPLICATION

(21) Application number: 88104856.5

(22) Date of filing: 25.03.88

(51) Int. Cl.⁴ **H01L 39/14**

(30) Priority: 27.03.87 JP 75424/87

(43) Date of publication of application:
05.10.88 Bulletin 88/40

(84) Designated Contracting States:
DE FR GB

(71) Applicant: SUMITOMO ELECTRIC INDUSTRIES
LIMITED
No. 15, Kitahama 5-chome Higashi-ku
Osaka-shi Osaka 541(JP)

(72) Inventor: Sawada, Kazuo c/o Osaka Works of
Sumitomo El.Ind.
1-3 Shimaya 1-chome Konohana-ku
Osaka(JP)
Inventor: Ohkura, Kengo c/o Osaka Works
Sumitomo El.Ind.Ltd.
1-3 Shimaya 1-chome Konohana-ku
Osaka(JP)
Inventor: Ohmatsu, Kazuya c/o Osaka Works
Sumitomo El.Ind.
1-3 Shimaya 1-chome Konohana-ku
Osaka(JP)

(74) Representative: Kuhnen, Wacker & Partner
Schneggstrasse 3-5 Postfach 1553
D-8050 Freising(DE)

(54) Method of using superconductor.

(57) A method of using a superconductor having a critical temperature $T_C$ being in excess of 50 K utilizes a superconducting phenomenon at a working temperature $T_{OP}$ satisfying $[T_C - T_{OP}] \geq 20$ K.

FIG.1

EP 0 285 028 A2

## Method of Using Superconductor

## BACKGROUND OF THE INVENTION

Field of the Invention

The present invention relates to a method of using a superconductor in the field of a function element such as a Josephson device or in the field of an energy device such as a transmission line or a high current density magnet, for example.

Description of the Prior Art

In general, NbTi or the like is well known as a superconductive material. A superconductor of NbTi, having a critical temperature $T_C$ of about 9 K under magnetic field strength of 0 kG, has been used at a temperature of 4 K with employment of liquid helium as a cooling medium.

Another superconductive material of $Nb_3Sn$, having a critical temperature $T_C$ of 18 K under magnetic field strength of 0 kG, has also been used at the temperature of liquid helium serving as a cooling medium, i.e., at the temperature of 4 K.

In the case of the aforementioned superconductor prepared by a superconductive material of NbTi, difference between the critical temperature $T_C$ of about 9 K and a working temperature $T_{OP}$ of 4 K (temperature of liquid helium) has been only about 5 K.

In the superconductor prepared by a superconductive material of $Nb_3Sn$, difference between the critical temperature $T_C$ of 18 K and the working temperature $T_{OP}$ of 4 K has been only 14 K.

Thus, in each of the conductors prepared by such superconductive materials, the difference between the critical temperature and the working temperature has been so small that an available superconductive state is extremely unstable.

Recently being obtained are superconductive materials having critical temperatures $T_C$ which are in excess of 50 K. However, such superconductive materials of high critical temperatures have been developed in order to employ a cooling medium of a higher temperature, such as liquid nitrogen. Thus, a cooling medium of a relatively high temperature such as liquid nitrogen is employed in use of such superconductive materials having high critical temperatures. As the result, superconductive states thereof are apt to be instabilized not only with respect to temperatures, but also with respect to magnetic fields and current values.

## SUMMARY OF THE INVENTION

An object of the present invention is to provide a novel method of using a superconductor, which can stably derive a superconducting phenomenon.

The method of using a superconductor according to the present invention is characterized in that a superconducting phenomenon of a superconductor having a critical temperature $T_C$ being in excess of 50 K is utilized so that a working temperature $T_{)P}$ satisfies $[T_C - T_{OP}] \geq 20$ K.

The superconductor is preferably used at a working temperature $T_{OP}$ satisfying $[T_C - T_{OP}] \geq 50$ K, to utilize a more stable superconducting phenomenon.

As the result of various studies made to enable utilization of a more stable superconducting phenomenon, it has been found out that a stable superconducting phenomenon is obtained by setting a working temperature $T_{OP}$ to satisfy $[T_C - T_{OP}] \geq 20$ K. The present invention is based on such a point of view. In order to satisfy the aforementioned condition, a superconductive material of a high critical temperature is employed. Namely, in use of a superconductor formed by a superconductive material of a relatively high critical temperature, a cooling medium of a relatively high temperature, which is apt to be considered employable, is rather avoided but a cooling medium of a lower temperature is employed to implement a more stable superconducting phenomenon.

A superconductor available for the present invention is not particularly restricted so far as the same is formed by a superconductive material whose critical temperature $T_C$ is in excess of 50 K, such as a superconductive ceramics being generally expressed in a formula AaBbCc, for example. In the above

formula, $\underline{A}$ represents at least a single sort of element within those belonging to the groups Ia, IIa and IIIa of the periodic table. $\underline{B}$ represents at least a single sort of element within those belonging to the groups Ib, IIb and IIIb of the periodic table. $\underline{C}$ represents at least a single sort of element selected from a group of oxygen, carbon, nitrogen, fluorine and sulfur. The elements belonging to the group Ia of the periodic table are H, Li, Na, K, Rb, Cs and Fr. The elements belonging to the group IIa of the periodic table are Be, Mg, Ca, Sr, Ba and Ra. The elements belonging to the group IIIa of the periodic table are Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No and Lr.

The elements belonging to the group Ib of the periodic table are Cu, Ag and Au and the elements belonging to the group IIb of the periodic table are Zn, Cd and Hg, while the elements belonging to the group IIIb of the periodic table are B, Al, Ga, In and Tl.

Preferably, a higher critical temperature can be implemented by preparing $\underline{A}$ by a material containing at least two sorts of elements within those belonging to the groups Ia, IIa and IIIa of the periodic table. Therefore, a cooling medium can be selected from more types, in order to satisfy $[T_C - T_{OP}] \geq 50$ K. More preferably recommended is employment of a material containing at least copper as $\underline{B}$ and at least oxygen as $\underline{C}$.

In more concrete terms, examples of the superconductive material of a high critical temperature expressed in the aforementioned general formula are $(Y, Ba)_3Cu_2O_7$, $Y_{0.4}Ba_{0.6}CuO_3$ and the like.

A cooling medium employed in the inventive method may be prepared by any material so far as difference between the critical temperature $T_C$ and the working temperature $T_{OP}$ can be 20 K. Thus, the cooling medium is not restricted to liquid helium but may be prepared by gaseous helium, liquid nitrogen, gaseous nitrogen or the like, which is appropriately selected in response to the critical temperature $T_C$ of the superconductive material.

According to the present invention, difference between the working temperature $T_{OP}$ and the critical temperature $T_C$ is at least 20 K, i.e., an allowable temperature range with respect to the critical temperature $T_C$ is at least 20 K, whereby more stable superconductivity can be utilized. For example, superconducting operation can be stably performed in a device such as a coil employing a wire rod prepared by the aforementioned superconductive material, thereby to effectively prevent such an accident that a cooling medium is boiled by heating caused by disappearance of a superconducting phenomenon. Also in application to an electronic device such as a Josephson device, heat generation etc. is so hardly caused that the device is not substantially degraded in characteristic, thereby to implement a highly reliable device, which can be stably operated. Further, heat radiation structure of a heat sink etc. may be reduced or omitted as the case may be. In addition, stable operation leads to reduction in thermal noise, whereby the signal-to-noise ratio of the device can be effectively improved.

The present invention is adapted to use a superconductor of a high critical temperature at a lower temperature to increase current density, whereby the superconductor and peripheral devices thereof can be reduced in size. According to the present invention, further, a superconductor can be stably operated to be effectively applied to a power device such as that for nuclear fusion, an accelerator, a linear motor generator, etc.

In application to the aforementioned electronic device, on the other hand, thermal noise is reduced and the signal-to-noise ratio is improved. Thus, it is pointed out that an excellent effect can be attained in an electronic device such as an infrared sensor of high sensibility or a device for a supercomputer.

These and other objects, features, aspects and advantages of the present invention will become more apparent from the following detailed description of the present invention when taken in conjunction with the accompanying drawing.

BRIEF DESCRIPTION OF THE DRAWING

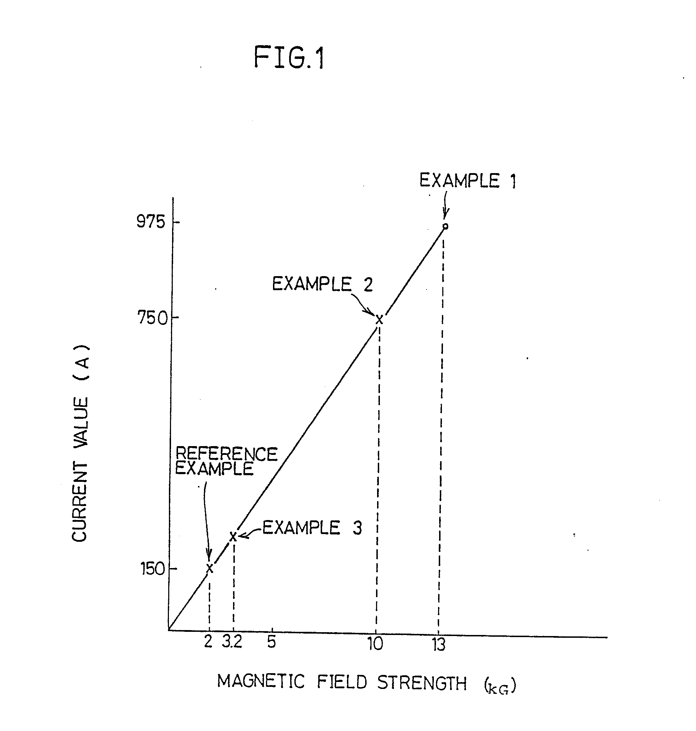

Fig. 1 illustrates levels of magnetic field strength causing disappearance of superconducting phenomenons in Examples of the present invention and reference example and current values at such levels of magnetic field strength.

## DESCRIPTION OF THE PREFERRED EMBODIMENTS

Superconductors (linear bodies) being in composition of $Y_{0.4}Ba_{0.6}CuO_3$ were prepared. The critical temperature $T_C$ of such superconductors was 80 K under magnetic field strength of 8 kG. Four types of cooling mediums were prepared by liquid nitrogen having a temperature of 77 K, helium gas having a temperature of 58 K, liquid hydrogen having a temperature of 20 K and liquid helium having a temperature of 4 K respectively, to test stability of superconducting phenomenons of these superconductors. The case of employing the liquid nitrogen corresponds to reference example, in which difference $[T_C - T_{OP}]$ was 3 K.

The test was performed by energizing the superconductors being cooled by the respective cooling mediums and increasing magnetic field strength, to measure the levels causing disappearance of superconducting phenomenons. Table 1 shows the result.

It is understood from Table 1 that a superconducting phenomenon was still maintained in each Example of the present invention. Fig. 1 also shows current values at the levels of magnetic field strength causing disappearance of superconducting phenomenons in Examples 2 and 3 of the present invention and the reference example, for reference. Although the current value under magnetic field strength of 13 kG has been plotted as a reference value in Fig. 1 with respect to Example 1, the superconducting phenomenon was not disappeared in Example 1 even if the magnetic field strength was increased to 13 kG, as obvious from Table 1.

Table 1

|  |  | Colling Medium | Working Temperature (Top) | Tc-Top | Result |
|---|---|---|---|---|---|
| Example | 1 | Liquid He | 4 K | 76 K | No dissapearance up to 13 kG Stably operated at 10 kG/sec. |
|  | 2 | Liquid Hydrogen | 20 K | 60 K | Disappeared at 10 kG Instabilized at 10 kG/sec. Stabilized at 5 kG/sec. |
|  | 3 | He Gas | 58 K | 22 K | Disappeared at 3.2 kG Stabilized at 5 kG/sec. |
| Reference Example |  | Liquid Nitrogen | 77 K | 3 K | Disappeared at 2 kG Still unstable at 5 kG/sec. |

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of using a superconductor having a critical temperature $T_C$ being in excess of 50 K, said method utilizing a superconducting phenomenon at a working temperature $T_{OP}$ satisfying $[T_C - T_{OP}] \geq 20$ K.

2. A method of using a superconductor in accordance with claim 1, wherein said working temperature $T_{OP}$ satisfies $[T_C - T_{OP}] \geq 50$ K.

3. A method of using a superconductor in accordance with claim 1, wherein said superconductor is prepared by a superconductive material which is generally expressed in a formula AaBbCc, where A represents at least a single sort of element selected from a group of those belonging to the groups Ia, IIa and IIIa of the periodic table, B represents at least a single sort of element selected from a group of those belonging to the groups Ib, IIb and IIIb of the periodic table, C represents at least a single sort of element selected from a group of oxygen, carbon, nitrogen, fluorine and sulfur and a, b and c represent numbers showing composition ratios of A, B and C respectively.

4. A method of using a superconductor in accordance with claim 3, wherein
said $\underline{A}$ contains at least two sorts of elements selected from said group of those belonging to the groups Ia, IIa and IIIa of the periodic table.

5. A method of using a superconductor in accordance with claim 3, wherein
said superconductive material contains at least copper as said $\underline{B}$ and at least oxygen as said $\underline{C}$.

# FIG.1

EXAMPLE 1

EXAMPLE 2

REFERENCE
EXAMPLE

EXAMPLE 3

975

750

150

CURRENT VALUE (A)

2  3.2  5     10   13

MAGNETIC FIELD STRENGTH (kG)